# EUROPEAN PATENT SPECIFICATION

(11) **EP 2 945 918 B1**
(45) Date of publication and mention of the grant of the patent: **27.02.2019**
(21) Application number: 13700236.6
(22) Date of filing: 15.01.2013
(51) Int. Cl.: C04B 35/45, C04B 35/626, C04B 35/64, H01L 39/24

(54) **RAPID SOLID-STATE REACTION OF OXIDES WITH ULTRAVIOLET RADIATION**
SCHNELLE OXIDENUMSETZUNG IN FESTER PHASE MIT ULTRAVIOLETTER STRAHLUNG
REACTION RAPIDE D' OXIDES A L'ETAT SOLIDE PAR IRRADIATION ULTRAVIOLET

(43) Date of publication of application: 25.11.2015
(73) Proprietor: Müller, Karl Alex, 8125 Zollikerberg (CH); Shengelaia, Alexander, Tbilisi 0194 (GE)
(72) Inventor: MÜLLER, Karl Alex, CH-8125 Zollikerberg (CH); SHENGELAIA, Alexander, Tbilisi 0194 (GE); DARASELIA, Dimitri, Tbilisi 0179 (GE); JIBUTI, Zurab, Tbilisi 0179 (GE); JAPARIZIDE, David, Tbilisi 0194 (GE)
(74) Representative: Strässle, Simon
(86) International application number: PCT/EP2013/050664
(87) International publication number: WO 2014/111130

(56) References cited:
- EP-A1- 1 747 723
- WO-A1-89/03125
- WO-A1-90/04568
- WO-A1-2012/140684
- WO-A2-2004/012277
- DE-A1-102009 004 533

## Description

### TECHNICAL FIELD

The present invention relates to a method for producing ceramic materials according to claim 1. The method according to invention aims in particular at providing a fast, simple, and cheap method for oxide material such as cuprate synthesis. Importantly, the present invention suggests a method that may be easily implemented into existing production lines, improving yield and quality significantly, while reducing production time and energy consumption.

### PRIOR ART

Today, efficient energy transmission is absolute key to success for any economic system. In particular electric power needs often to be shifted from the place of production to the place of consumption, sometimes over distances covering thousands of kilometers. As since the late 1980ies, the material of choice for such an electrical power transmission is known indeed: high-temperature superconductors. Yet, even after more than two decades after the discovery of cuprate superconductivity, industry still struggles with the large-scale synthesis and -processing of these brittle ceramic compounds. For example, the economical mass production of long cables or tapes from these exceptional materials is still a major challenge, yet of enormous commercial and environmental relevance.

High-temperature superconductors, manganites with colossal magneto-resistance, and many other advanced and for modern technologies downright essential oxide materials are usually obtained through time- and energy-consuming solid-state synthesis. These materials are not only used for the aforementioned electrical power transmission but also for application including high-magnetic field or computer science technologies to name only a few.

WO 2004/012277 A2 teaches a metal organic chemical vapor deposition process for producing films of oxide materials whilst using visible light.

Current methods make use of continuous heating of well-mixed reactants in powder form or precursor thin films in an oven at high temperatures (800 to 1200 degrees Celsius) for tens or even hundreds of hours. During this process, a solid-state synthesis reaction occurs (*cf* review of L. C. Pathak and S. K. Mishra, Supercond. Sci. Technol 18, R67-R89 (2005)).

It seems that the duration of this heating and tempering with such high temperatures correlates with the process product quality. But high-quality production not only requires a lot of reaction time, it is also highly energy intense. Moreover, during the aforementioned long-term high-temperature heating, there is substantial risk that some of the ceramic components evaporate, which leads to an unfavorable change in stoichiometry, and ultimately to products of inferior quality. For some oxygen-content sensitive materials, high-temperature heating, as known from and largely used in the state of the art, introduces even oxygen deficit, which necessitates additional processing stages in order to restore a desired oxygen content required to guarantee a minimum material quality. Consequently, production costs of said ceramic material are high.

In recent years, a microwave heating method has been developed as a new tool for fast solid-state synthesis of inorganic materials. Up to now, different inorganic solids have been prepared by means of microwave irradiation. These reactions have been found to require much shorter reaction times (*cf.* K. J. Rao et al., Chem. Mater. 11, 882-895 (1999)). This new microwave approach led to a significant reduction of the synthesis time and the energy consumption (*cf.* EP 0 336 306).

In order for the heating through microwave irradiation to be effective, the starting oxides must, however, have proper absorption characteristics, the latter not being intrinsic to every ceramic material. It is therefore difficult to obtain a wide range of ceramic products by means of microwave power. Another undesirable feature often associated with microwave heating is the phenomenon of "thermal runaway", wherein a sample subjected to a constant source of microwave power has, at the beginning, a slow rise in temperature, whereupon the temperature suddenly increases at a much higher rate, ultimately destroying the sample. This effect makes the process even more delicate, as generally, it is difficult to control the temperature during the microwave irradiation process, which also leads to problems with reproducibility of the whole manufacturing process.

Some attempts using microwave irradiation have been made to synthesize technologically important high-temperature superconductors, such as YBa₂Cu₃O₇₋ₓ. It was found that indeed it is possible to synthesize this compound within 3.5 hours, which is much faster as compared to conventional heating in a furnace device. However, the obtained superconductor material was of poor quality (*cf.* A. Agostino et al., Supercond. Sci. Technol. 17, 685 (2004)).

### SUMMARY OF THE INVENTION

It is therefore an object of the present invention to reduce the production time of synthesis of ceramic materials, in particular of oxide materials such as cuprates or manganites or the like while maintaining a high quality of the final process product.

These and further objects are achieved by a method for solid-state synthesis of oxide materials, in particular cuprates according to claim 1.

The method according to invention comprises or includes or consists of the following steps:
providing to a heating device starting material in a providing step (a) in amounts effective to produce the ceramic material; hereinafter
applying in a treatment step (b) a treatment to said starting material, the treatment step (b) including:
   heating the starting material by means of the heating device in a heating step (c) to a first reaction temperature, wherein the first reaction temperature is in a range from 650 degrees Celsius to 1200 degrees Celsius, preferably in a range from 750 degrees Celsius to 1000 degrees Celsius, more preferably in a range from 850 degrees Celsius to 950 degrees Celsius, and in particular of 900 degrees Celsius, and
   irradiating said starting material during at least a first predefined period of time with ultraviolet light in a irradiation step (d) during at least part of and/or after the heating step (c).

Preferably, the method comprises a further step of mixing the starting materials. The starting materials are preferably oxide material powders. A powder mixture from the starting material may be prepared by mixing the starting material powders. After preparing said powder mixture, it may be pressed into pellets by means of a standard press, wherein the pellets preferably have a diameter of about 2 to 30 millimeters and a thickness of about 0.5 to 3 millimeters. Hereinafter, the treatment step (b) may be applied to such a pellet. The starting material is to be understood as precursor material or precursor, often this is an oxide, e.g. a metal oxide.

Alternatively, the starting material may be deposited in a thin layer of *e.g.* 10 nanometers to 1 micrometer on an adequate buffer layer. Preferably, the thin layer or thin film is at least one monolayer or a plurality of monolayers thick. Preferably, the thin film coating resulting from depositing said starting material onto the structured substrate is at least one or a plurality of monolayers of the resulting material thick. As an example a cuprate superconductor may be deposited expitaxially on a substrate, wherein the substrate is preferably textured in order to optimize current density. The textured substrate may comprise on an alloy substrate deposited layers of Yttrium oxide, Yttrium stabilized Zirconia, and/or a top layer of Cerium oxide. Each of these three layers on the alloy substrate may be 50 or 75 to 100 nm thick. The starting material may be deposited by an adequate method like liquid phase or molecular beam epitaxy, pulsed laser deposition (PLD), metal-organic deposition (MOD), or other adequate methods such as used more recently in the second generation high temperature superconducting ribbon production like the ion beam assisted deposition (IBAD) method.

According to an embodiment, the irradiation step (d) the ultraviolet light is irradiated during at least a first predefined period of time with a light irradiance in a range from 0.5 to 5 watts per centimeter (W/cm²), preferably in a range from 1 W/cm² to 4 W/cm², more preferably in a range from 1.5 W/cm² to 3 W/cm², and in particular of about 2 W/cm². Surprisingly, it was found that ultraviolet-light irradiation of the starting material during the heating leads not only to a much faster and more efficient production method, but also to process products, *i.e*. ceramic materials like cuprates, with high quality.

Recently, ultraviolet assisted metal-organic chemical vapor deposition (MOCVD) [*cf.* US 2012/258,863 A1] and metal-organic deposition (MOD) [*cf.* H. Matsui *et al.,* Physica C 471, 960 (2011)] processes were proposed and applied for YBCO thin film deposition. However, in these processes the role of ultraviolet irradiation was only to assist in decomposition of the metal-organic precursor compounds and therefore ultraviolet light was used prior to the synthesis of thin films. The solid-state synthesis then was performed by conventional thermal annealing in furnace. The present invention is, however, distinct over such a procedure, as it was found, that ultraviolet irradiation of the starting material during the synthesis has a surprising effect in improving the synthesis significantly.

This insight led to an embodiment of the present invention, wherein this embodiment relates to a method including a process step during which direct ultraviolet irradiation on the sample is combined with thermal treatment, *e.g*. irradiation by halogen lamps. It was found that this ultraviolet-light irradiation increases the solid-state reaction rate between inorganic starting oxides. Therefore the process according to invention is more general than just decomposition or photo-excitation of metal-organic precursors and hence, it can be effectively used for the synthesis of the complex oxide materials starting from organic as well as inorganic precursors.

The present invention also relates to fast solid-state synthesis of oxide materials by using a combined thermal and ultraviolet irradiation. According to a preferred embodiment of the invention, the starting oxides are mixed in appropriate, preferably stoichiometric proportions to produce a homogeneous powder mixture. This mixture is pressed into the pellet prior to synthesis. The obtained pellet is subjected to simultaneous thermal and ultraviolet irradiation in a heating device. The starting material may also be deposited in a layer by means of the above mentioned methods like MOD, PLD, IBAD,.... For thermal irradiation halogen lamps are used, which ensures a rapid thermal heating of the initial mixture of oxides. The additional ultraviolet lamp plays a role of additional energy and reaction source during the solid-state synthesis. It was found that the ultraviolet irradiation is crucial and stimulates the solid-state reaction, which proceeds much faster and at lower temperatures compared to conventional heating procedure in a furnace.

The synthesis and post treatment of the obtained material can be performed in a flow of air, oxygen, or other gases, if necessary.

It was found that with the method according to invention it is possible to perform a fast synthesis of bulk oxide materials which have a thickness of the order of millimeter. Hence, the method may also be used in preparation of the thin films of the oxide or ceramic materials, e.g. like cuprates or the like, which have a high technological importance.

According to another preferred embodiment, conventional MOD processes of thin-film deposition of ceramic materials like high-temperature superconducting cuprates and other advanced oxides on substrates are improved by including a process step of ultraviolet-light irradiation during the synthesis process (preferably in combination with thermal irradiation) and preferably also during the decomposition process of metal-organic precursors. The method according to invention is advantageous as it reduces the time of thin-film preparation of these materials.

Preferably, the in the heating step (c) heated up material is kept at the first reaction temperature for a second predefined period of time, wherein, preferably, the second predefined period of time of ultraviolet-light irradiation is in a range from about 10, 20 or 30 seconds to about 5 hours, preferably in a range from about 1 minute to about 1 hour, more preferably in a range from 15 minutes to 45 minutes, and in particular of about 20minutes or about 30 minutes.

According to a preferred embodiment, the first predefined period of time is at least part of the second predefined period of time.

The ultraviolet light may be irradiated continuously and/or in form of one or a plurality of consecutive light pulses. Preferably, the shorter the overall period of irradiation the higher the intensity of the light should be. One can irradiate the sample during a certain period of time with a predetermined intensity, or irradiate the same sample for a shorter period of time with a higher intensity. It is also possible to irradiate the sample continuously with a modulated intensity or irradiation.

If the ultraviolet lamp is operated in pulse mode, a length of the light pulses is preferably in a range from 100 nanoseconds to 2 milliseconds, preferably in a range from 1 microsecond to 500 microseconds, and in particular of 100 microseconds. The pulse length may be adapted to achieve a desired irradiation effect depending on the intensity or irradiance of the ultraviolet-light source.

Preferably, the starting material is provided to the heating device in substantially stoichiometric amounts. Stoichiometric amount means that the different components of the starting material, *i.e.* different metal oxides or other oxides, are provided in a stoichiometric ratio, which is in general a composition effective to produce the desired ceramic material.

According to a particularly preferred embodiment, the starting material is heated up by irradiation of electromagnetic waves, preferably by irradiation of microwaves or by means of halogen lamps, wherein the wattage of the light source has to be chosen such that the lamp may deposit sufficient energy in the heating device and/or the sample to heat the sample to the desired temperature. The temperature of the sample may be controlled and adjusted as known from the state of the art.

Preferably, if *e.g.* pellets or other preferably pressed ceramic material are prepared, the starting material is provided as a homogeneous mixture of powder materials.

According to another aspect of the invention, the ultraviolet-light or photo-assisted synthesis may also be applied in the field of thin-film production. This may be used in the production of cables or tapes or the like, *e.g.* from YBaCuO-materials as described below. A particularly preferred embodiment of the present invention provides a method for preparing a thin film of ceramic materials, in particular of oxide materials, in particular cuprates, according to the method as described above and including the further steps of:
in a providing step, dissolving the starting material in substantially stoichiometric amounts in a solvent; hereinafter
coating a substrate by a dip and/or spin coating technique to produce a coated substrate; hereinafter
in a treatment step, heating the coated substrate by applying the heating step (c) as described above, preferably by means of halogen lamps and, preferably, at about 500 degrees Celsius the coating is irradiated with ultraviolet light for a predefined 20 minutes period and, preferably, at about 900 degrees Celsius and during about 20 minutes; wherein
the coated substrate is irradiated with ultraviolet light by applying the irradiation step (d) as described above during at least part of said heating step (c).

Preferably, after dip coating or spin coating the substrate, the deposited thin-film coating on the substrate is dried, preferably at a temperature in a range from about 200 degrees Celsius to about 250 degrees Celsius, preferably for about 10 minutes to about 15 minutes. Preferably, after the heating step (c), the thin-film coating deposited on the substrate is annealed in oxygen atmosphere. The annealing is performed at a second temperature, wherein the second temperature being preferably lower than the first temperature, and most preferably about 550 degrees Celsius. The annealing is performed preferably during a predefined period of time of preferably 10 minutes to 30 minutes, more preferably of 20 minutes.

Preferably, the heated and irradiated thin-film coating on the substrate is cooled down to room temperature under oxygen flow. This ensures proper oxygen content of the sample. Preferably, before said heating step (c), the coating of the substrate is irradiated with ultraviolet-light irradiation applying the irradiation step (d) preferably during a period of time in the range of 10 minutes to 15 minutes.

Another preferred embodiment of the present invention provides a method for preparing a thin film of ceramic materials, in particular cuprates, according to the method as described above, wherein a substrate to be coated by the thin film is translated through a deposition chamber that comprises preferably at least one vacuum chamber and that comprises at least one heater, at least one starting material delivery system, and a substrate translation system for translating the substrate through a deposition zone of the metal oxide deposition chamber,
wherein, during the providing step (a), the substrate translating through the deposition zone is heated in a heating step (c) by the heater and successively impinged upon by starting material by means of the starting material delivery system in order to deposit a coating thereon,
and wherein, during the treatment step (b), the coating is irradiated in the irradiation step (d) by ultraviolet light.

Preferably, the starting material is provided to the substrate by means or a method selected from the group comprising metal-organic deposition, liquid phase epitaxy, ion-beam epitaxy, pulsed laser deposition, ion-beam assisted deposition.

The present invention as described above may be used for synthesis of a cuprate high-temperature conductor material, *e.g*. in tape form and in particular of YBa₂Cu₃O₇₋ₓ.

All temperatures and time periods mentioned above may be adjusted to the specific ceramic material to be produced.

The heating step (c) may also be performed in a conventional furnace. Wherein the ultraviolet light is guided into or produced in the furnace.

This shows, that existing production devices may only be supplemented with an ultraviolet-light source, which means that it is simple, easy, and cheap to upgrade existing devices with a lamp or the like in order to enjoy the surprisingly efficiency-improving influence of ultraviolet-light irradiation on the synthesis of said ceramic materials.

According to another embodiment of the invention, the powders of starting reagents having proper purity are well mixed in stoichiometric ratio and subsequently pressed to form a pellet (sample) of a required shape, which is then placed on the surface of support and irradiated by means of a light source providing high intensity radiant flux. The irradiation by the light causes solid-state reaction between the reagents to produce the target product. It should be noted that while the wide spectrum light flux encompassing visible, infrared and ultraviolet radiation ranges may be used for irradiation. Also a relatively narrow spectrum range can be used for some ceramic materials, *e.g*. ultraviolet light with visible or/and infrared light jointly.

The radiant flux density, the irradiance, or intensity of the ultraviolet light that is necessary for enabling solid-state reaction depends on the particle sizes of oxide materials and crystallites produced on the substrate according to the aforementioned methods (MOD, PLD, IBAD, ...), on the optical absorption properties thereof, and on the temperature of the sample. The process parameters - the sample temperature, irradiation intensity and its duration are adjusted independently from each other. The energy absorbed by the sample during irradiation heat the sample up to certain temperature. The reactor may be constructed in such a fashion as to allow reducing the temperature by creating a flow of air or some other gas suitable for use in the process within the reactor, or elevating the temperature by applying proper amount of voltage onto the resistive heater or a microwave source or another heat source, and, in this manner, to allow of adjusting the temperature separately independent of the ultraviolet light intensity. An atmosphere of a gas suitable for the synthesis process, such as, for example, oxygen, can be created in the quartz tube. Usually, the sample heating temperature is observed by means of a thermocouple probe or a pyrometer.

The efficiency of the photo-stimulated solid-state reaction is controlled in accordance with physical properties of the obtained material (X-ray diffraction analysis, magnetic and electric properties, electron paramagnetic resonance, etc.).

### BRIEF DESCRIPTION OF THE DRAWINGS

Preferred embodiments of the invention are described in the following with reference to the drawings, which are for the purpose of illustrating the said embodiments of the invention and not for the purpose of limiting the same. In the drawings,
- Fig. 1: shows a schematic illustration of the heating setup for performing the method according to invention;
- Fig. 2: shows vibrational sample magnetometer measurement results of samples produced under ultraviolet and halogen irradiation;
- Fig. 3: shows vibrational sample magnetometer measurement results of samples produced under halogen irradiation (no ultraviolet irradiation);
- Fig. 4: shows the temperature dependence of the magnetic moment of sample #1 being produced under ultraviolet and halogen irradiation and after oxygen annealing, wherein the magnetic moment is measured by means of a vibrational sample magnetometer;
- Fig. 5: shows the temperature dependence of the magnetic moment of sample #2 being produced under halogen irradiation and after oxygen annealing, wherein the magnetic moment is measured by means of a vibrational sample magnetometer;
- Fig. 6: shows the temperature dependence of the magnetic moment of sample #3 being produced in a conventional furnace with no light irradiation, and after oxygen annealing, wherein the magnetic moment is measured by means of a vibrational sample magnetometer;
- Fig. 7: shows the temperature dependence of the magnetic moment of a LSCO 0.16 sample prepared by photo-stimulated synthesis at 1000°C, wherein the magnetic moment is measured by means of a vibrational sample magnetometer;
- Fig. 8: shows the volume fraction of the superconducting phase in samples produced at various temperature, wherein the samples were obtained either by application of the photostimulated according to invention (square symbols) or by traditional processes (star symbols); and
- Fig. 9: shows the dependence of the magnetic moment of a manganite sample measured in a magnetic field of 100 gauss.

### DESCRIPTION OF PREFERRED EMBODIMENTS

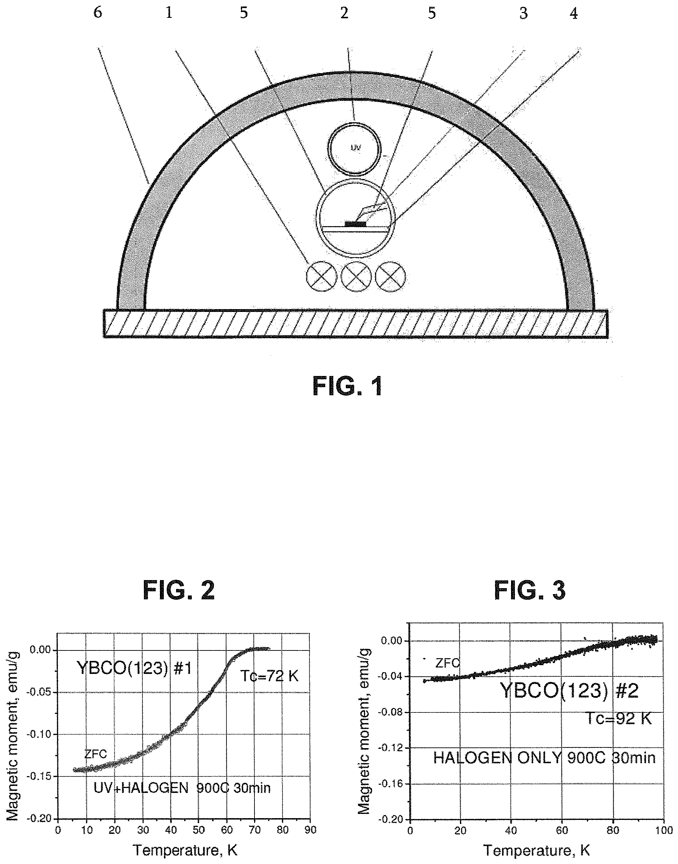

The apparatus according to **Figure 1** may be used for carrying out the method according to invention. It comprises light sources (1,2) with three collinearly arranged halogen lamps (1), each with 1 kilowatt electrical power, and with a Wildfire IronArc® metal halide ultraviolet lamp LMP-400D (2) with a wattage of 400 watts. A color temperature of the halogen lamps is 3'200 K, a radiant flux is 26'000 lumen each. A sample (3) is placed on a sample holder, *i.e.* on a surface of a flat transparent quartz plate (4), which is mounted into a portion of a high-quality optical quartz tube (5). This construction allows performing an irradiation process in a gas atmosphere, *e.g*. an oxygen atmosphere. The ultraviolet lamp (2) is mounted above quartz tube, collinearly to the halogen lamps (1). The sample temperature is measured by means of a fast response K-type thermocouple (5), wherein the thermocouple (5) is in direct contact with the sample surface. The setup is covered by a ceramic arc (6). The arc (6) is made from Kersil. Said arc (6) has a glazed inner surface acting as a reflector for electromagnetic waves.

As an ultraviolet-light source a Metal Halide UV lamp LMP-400D with 400 W electric power. This lamp provides UV light with main intensity in 250 to 400 nm wavelength range. The intensity of light from this lamp is about 2 W/cm² within this wavelength interval. Other ultraviolet-light sources may be used.

### Example: synthesis of a high-temperature superconductor YBa₂Cu₃O₇₋ₓ

La₂O₃, BaCO₃, and CuO powders of at least 99.99% purity are thoroughly mixed in stoichiometric proportions in an agate mortar to produce a powder mixture. Hereinafter, the powder mixture is pressed with a 5 ton press into pellets with a diameter of about 12 mm and a thickness of about 0.4 mm to 1 mm. These pellets or samples are then irradiated at different conditions by means of the above described setup.

Sample #1 was irradiated by both ultraviolet and halogen lamps at 900 degrees Celsius for about 30 minutes. Sample #2 was irradiated only by the halogen lamps at 900 degrees Celsius for about 30 minutes. The control sample #3 was inserted into a conventional furnace, preliminarily heated to about 900 degrees Celsius and removed therefrom after 30 minutes. All the reactions with samples #1, #2, and #3 were performed in air.

Black color ceramic samples with a low-ohm resistance were obtained by this synthesis. A subsequent X-ray diffraction analysis showed that the sample #1 formed a proper YBa₂Cu₃O₇₋ₓ (hereinafter in the text: YBCO, in the figures: YBCO(123)) phase. Samples #2 and #3 partially formed the YBCO structure, but contained a large amount of impurity phases.

The superconducting properties of samples #1 to #3 were analysed by measurement of the temperature dependences of the magnetisation. A vibrational sample magnetometer produced by CRYOGENIC Ltd., operating in temperature range from 2 to 300 K and in a magnetic field up to 5 T was used. The samples were cooled in zero magnetic field down to 2 K, then a magnetic field *B* = 20 G was applied and the magnetization was measured during sample heating. This type of measurement is known as zero field cooling (ZFC) measurement. Measurements were performed by cooling the samples from above the critical temperature *T*_{c}, below which the sample is superconducting, while a magnetic field of *B* = 20 G was applied. This type of measurement is known as field cooling (FC) measurement. If the sample is a superconductor, a negative magnetic moment of diamagnetic origin is induced due to screening effect, which disappears above the transition temperature *T*_{c}. From these experiments, the critical temperature *T*_{c} and a volume fraction of the superconducting phase, which is proportional to magnetization value, can be obtained.

Experimental results of the above mentioned measurements are shown in **Figures 2** to **6****.** One can see that the superconducting volume fraction is about 3 times larger in sample #1, obtained by combined light irradiation from ultraviolet and halogen lamps, as compared to sample #2, irradiated only by the halogen lamps. This result demonstrates the crucial role of ultraviolet-light irradiation during the synthesis process.

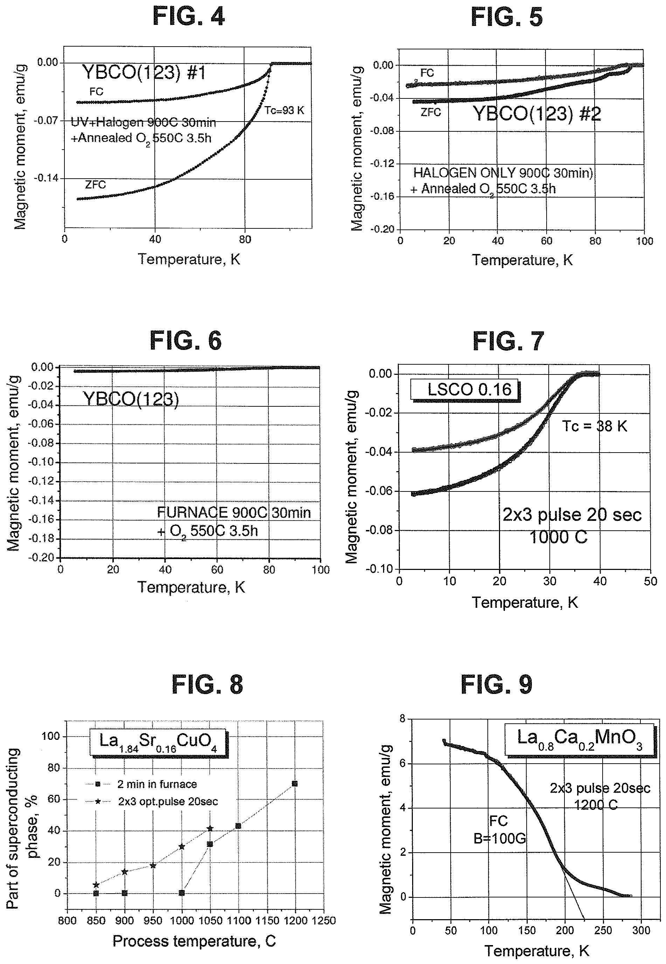

Since the superconducting properties of YBCO are very sensitive to the actual oxygen content in the sample, the measured samples were post-annealed in an oxygen flow for 3.5 hours at 550 degrees Celsius. **Figures 4** and **5** show the experimental results for samples #1 and #2 after said oxygen annealing. One can see that the oxygen annealing does not significantly change the critical temperature *T*_{c} or the volume fraction of the superconducting phase in sample #2, which was irradiated by halogen lamps. In contrast, in ultraviolet and halogen irradiated sample #1 a significant increase of both, *T*_{c} and the volume fraction of the superconducting phase is observed. Quantitative calculations based on ZFC magnetization results show that the sample #1 (after ultraviolet and halogen irradiation) has about 80 % of the superconducting phase, while sample #2 (halogen only) has about 20% of superconducting phase. This means that high-quality bulk superconductivity is obtained in sample #1.

The control sample #3, however, annealed in a conventional furnace for the same period of time, *i.e.* 30 minutes at 900°C, showed no superconductivity. Even after post-annealing in oxygen flow for 3.5 hours at 550 degrees Celsius, the superconducting volume fraction was only about 2 % as can be seen in **Fig. 6****.**

These experiments clearly demonstrate that fast solid-state synthesis takes place in YBCO under combined irradiation with ultraviolet and halogen lamps at temperatures 900°C and in time intervals as short as 30 minutes. This is also the reaction time in synthesis of thin films. So it is feasible to synthesize YBCO thin films within minutes by the process according to the present invention. It is worth to note that conventional synthesis of YBCO using a furnace is typically performed at 940°C and typically takes tens of hours.

Although the present invention has been described above with reference to specific embodiments thereof, it is to be understood that numerous modifications may be made without departing from the scope of the present invention as described herein. Hence, the present invention that has been described by reference to the processing of specific materials to produce a superconducting ceramic material comprising a particular superconducting phase, *i.e.* a Y-Ba-Cu-O ceramic system, is not limited to these specific embodiments. Processing in accordance with the invention is suitable for the production of other superconducting ceramic materials, such as those containing Tl-Ca-Ba-Cu-O, Sr-La-Cu-O, Ba-La-Cu-O, Ho-Ba-Cu-O, Gd-Ba-Cu-O, and similar phases. Superconducting ceramic materials not based on CuO may also be produced in accordance with the present invention. In general, processing according to this invention may be applied to any ceramic powder mixture which comprises a absorbing material and which can produce a superconducting phase upon heating.

### Thin film preparation procedure

YBa₂Cu₃O₇₋ₓ (YBCO) thin film preparation may include the following steps:
**1. Preparation of stable YBCO precursor solution using sol-gel method:** The starting materials for the precursor powder, *i.e.* the starting material, are yttrium acetate [Y(CH₃COO)₃·4H₂O], copper acetate [Cu(CH₃COO)₂·H₂O], and barium hydroxide [Ba(OH)₂·8H₂O], which are dissolved in a mixture of propionic acid and propylamine. The stoichiometric molar ratio of yttrium acetate, barium hydroxide, and copper acetate is 1:2:3. The oxide concentration of the solution is about 0.1 to 0.6 mol/l. Control of the ratio between the propionic acid and propylamine adjusts the viscosity to about 10-200 cp.
**2. Preparation of substrates:** Cleaning of substrates is done by diluted HCl, de-ionized water, acetone, and/or methanol in an ultrasonic cleaner. As a substrate for YBCO thin film deposition one can use polished SrTiO₃ or LaAlO₃ or other buffer layer or substate materials like *e.g*. Cerium oxide.
**3. Deposition of YBCO precursor solution on substrates:** Thin films can be deposited by dip coating or spin coating at 3'000-3'500 rpm on the polished substrate for 10 to 20 seconds. The at least one deposited thin film, *i.e.* the coating, is then dried at about 200 to 250 C for several minutes, *e.g*. 10 to 15 minutes in air.
**4. Synthesis of deposited thin films:** The thin film coating is synthesized by means of the above mentioned apparatus and by combined thermal and ultraviolet irradiation. In the first step films are treated only by ultraviolet irradiation during about 10 to 15 m minutes. Next, the halogen lamps are switched on and the precursor film coating is heated to 500 degrees Celsius. At about 500 degrees Celsius, the coated thin films are then irradiated by ultraviolet light during about 20 to 25 minutes to decompose organic materials which may be present in the precursor. Then coated thin film is further heated up to about 900 degrees Celsius. At 900 degrees Celsius the thin film is kept under oxygen flow for about 20 minutes. Afterwards the ultraviolet lamp is switched off and the samples are annealed at about 550 degrees Celsius under oxygen flow for about 20 minutes. At the end of this synthesis process, the halogen lamps are switched off and the thin films coating on the substrate is cooled down to room temperature under oxygen flow.

Another preferred embodiment includes preparing a high temperature superconductor La_{1.84}Sr_{0.16}CuO₄ (hereinafter referred to as LSCO 0.16).

The light source consisted of 19 halogen lamps of 1 kW in power each. The lamp color temperature was 3200 K and radiant flux was 26000 lumens. The irradiation was performed in pulse mode, each pulse length being 20 seconds. For these purposes, powdery materials La₂O₃, CuO and SrCO₃ in stoichiometric ratio were well mixed and pressed to form pellets of 12 mm in diameter and 0.5 mm in thickness. The sample was irradiated by 3 pulses at each side (2 minutes in total). The sample temperature was controlled by means of a fast response thermocouple and it was observed to be changing from 800°C to 1200°C in different processes. A low-resistive ceramics in black color were obtained as a result of the irradiation. The prepared samples were studied by X-ray diffraction analysis as well as by studying the temperature dependence of diamagnetic moment induced by magnetic field.

**Figure 7** shows the temperature dependence of the magnetic moment for the LSCO 0.16 sample prepared by photostimulated synthesis at 1000°C. This plot confirms the fact that the obtained sample is a superconductor with a critical temperature of superconducting transition of *T*_{c} = 38 K intrinsic to the superconducting ceramics LSCO 0.16.

For the purposes of comparison analysis of reaction performances of traditional and the photostimulated solid-state reactions, the same compound LSCO 0.16 was synthesized in a conventional furnace with the same duration (2 minutes) at varous temperatures. **Figure 8** shows the volume fraction of the superconducting phase in samples obtained by application of the photostimulated and traditional processes at different temperatures. As can be seen from the plot, using the traditional thermal synthesis samples can be synthesized only at temperatures above 1000°C, whereas the photostimulated solid-state reaction allows to obtain samples starting from 850°C.

Yet another preferred embodiment includes the photostimulated solid-state reaction process for the synthesis of other category of materials - manganites with colossal magnetoresistance. In particular, a manganite La_{0,8}Ca_{0.2}MnO₃ having perovskite structure was obtained. For this purposes, powdery materials La₂O₃, MnO₂ and CaCO₃ in stoichiometric ratio were well mixed and pressed to form pellets of 12 mm in diameter and 0.5 mm in thickness. The pellets were then irradiated in the above described photonic irradiation setup with 3 pulses at each side at 1200°C (exposure - 2 minutes in total). Ceramic pellets with black color were obtained after the exposure. The temperature dependence of the magnetic moment of the sample (in the magnetic field of 100 gauss) is shown in **Fig. 9****.** As can be seen from the figure, the sample is a feromagnetic material and it turns into a paramagnetic state above 220 K. For comparison, the same result is usually obtained by use of the traditional solid-state rection using furnace, which involves sintering during 14 hours at 950 °C, then during 24 hours at 1200°C and during 48 hours at 1300°C, and, finally, during 36 hours at 1350°C.

**LIST OF REFERENCE SIGNS**

| | | | |
|---|---|---|---|
| 1 | Light source for heating purpose | 4 | Sample holder |
| | | 5 | Quartz tube |
| 2 | Ultraviolet light source | 6 | Ceramic arc |
| 3 | Sample | | |

## Claims

1. A method for solid-state synthesis of ceramic materials, in particular of oxide materials, in particular cuprates, comprising or consisting of the following steps:
providing to a heating device (1) starting material (A,B,C) in a providing step (a) in amounts effective to produce the ceramic material; hereinafter
applying a treatment to said starting material (A,B,C) in a treatment step (b) by use of a solid-state reaction therein, the treatment step (b) including:
heating the starting material (A,B,C) by means of the heating device (1) in a heating step (c) to a first reaction temperature (*T*₁), wherein the first reaction temperature (*T*₁) is in a range from 650 degrees Celsius to 1200 degrees Celsius, preferably in a range from 750 degrees Celsius to 1000 degrees Celsius, more preferably in a range from 850 degrees Celsius to 950 degrees Celsius, and in particular of 900 degrees Celsius, and
irradiating said starting material (A,B,C) during at least a first predefined period of time (*t*₁) with ultraviolet light in a irradiation step (d) during at least part of and/or after the heating step (c).

2. The method according to claim 1, comprising the further steps of:
mixing the starting materials (A,B,C), in particular oxide materials, to prepare a powder mixture; hereinafter
pressing said powder mixture; and
applying the treatment step (b).

3. The method according to claim 1 or 2, wherein in the irradiation step (d) the ultraviolet light is irradiated during at least a first predefined period of time (*t*₁) with a light irradiance (4) in a range from 0.5 W/cm² to 5 W/cm², preferably in a range from 1 W/cm² to 4 W/cm², more preferably in a range from 1.5 W/cm² to 3 W/cm², and in particular of 2 W/cm².

4. The method according to any one of claims 1 to 3, wherein the heated up material (A,B,C) is kept at the first reaction temperature (*T*₁) for a second predefined period of time (*t*₂), wherein, preferably, the second predefined period of time (*t*₂) of ultraviolet-light irradiation is in a range from 10, 20 or 30 seconds to 5 hours, preferably in a range from 1 minute to 1 hour, more preferably in a range from 15 minutes to 45 minutes, and in particular of 20 minutes or 30 minutes.

5. The method according to claim 4, wherein the first predefined period of time (*t*₁) is at least part of the second predefined period of time (*t*₂).

6. The method according to any one of claims 1 to 5, wherein the ultraviolet light is irradiated continuously and/or in form of one or a plurality of consecutive light pulses.

7. The method according to claim 6, wherein a length of light pulses is in a range from 100 nanoseconds to 2 milliseconds, preferably in a range from 1 microsecond to 500 microseconds, and in particular of 100 microseconds.

8. The method according to any one of claims 1 to 7, wherein the starting material (A,B,C) is provided to the heating device (1) in substantially stoichiometric amounts.

9. The method according to any one of claims 1 to 8, wherein the starting material (A,B,C) is heated up by irradiation of electromagnetic waves, preferably by irradiation of microwaves or by means of halogen lamps (5).

10. The method according to any one of claims 1 to 9, wherein the starting material (A,B,C) is provided as a homogeneous mixture of powder materials.

11. A method for preparing a thin film of ceramic materials, in particular of oxide materials, in particular cuprates, including the method according to any one of claims 1 to 9 without claims 2 and 8, including the steps of:
in the providing step (a), dissolving the starting material (A,B,C) in substantially stoichiometric amounts in a solvent; hereinafter
coating a substrate preferably by a dip and/or spin coating technique to produce a coated substrate; hereinafter
in the treatment step (b), heating the coated substrate by applying the heating step (c) according to any one of the preceding claims, preferably by means of halogen lamps and, preferably, at 900 degrees Celsius and during 20 minutes; wherein
the coated substrate is irradiated with ultraviolet light by applying the irradiation step (d) according to any one of the preceding claims during at least part of said heating step (c).

12. The method according to claim 11, wherein, after dip coating or spin coating the substrate, the deposited thin film coating on the substrate is dried, preferably at a temperature in a range from 200 degrees Celsius to 250 degrees Celsius, preferably for 10 minutes to 15 minutes.

13. The method according to claim 11 or 12, wherein, after the heating step (c), the thin film coating deposited on the substrate is annealed in oxygen atmosphere
at a second temperature (*T*₂), the second temperature (*T*₂) being preferably lower than the first temperature (*T*₁), preferably 550 degrees Celsius;
and for a predefined period of time of preferably 10 minutes to 30 minutes, more preferably of 20 minutes.

14. The method according to any one of claims 11 to 13, wherein the heated and irradiated thin film coating on the substrate is cooled down to room temperature under oxygen flow.

15. The method according to any one of claims 11 to 14, wherein, before said heating step (c), the coating of the substrate is irradiated with ultraviolet irradiation applying the irradiation step (d).

16. A method for preparing a thin film of ceramic materials, in particular of oxide materials, in particular cuprates, including the method according to any one of claims 1 to 9 without claims 2 and 8, wherein a substrate to be coated by the thin film is translated through a deposition chamber that comprises preferably at least one vacuum chamber, and that comprises at least one heater, at least one starting material delivery system, and a substrate translation system for translating the substrate through a deposition zone of the metal oxide deposition chamber,
wherein, during the providing step (a), the substrate translating through the deposition zone is heated in heating step (c) by the heater and successively impinged upon by starting material by means of the starting material delivery system in order to deposit a coating thereon,
and wherein, during the treatment step (b), the coating is irradiated in the irradiation step (d) by ultraviolet light.

17. The method according to claim 11 or 16, wherein the starting material is provided to the substrate by a method selected from the group comprising metal-organic deposition, liquid phase epitaxy, ion-beam epitaxy, pulsed laser deposition, ion-beam assisted deposition.

18. Use of the method according to any one of the previous claims for synthesis of a cuprate high-temperature conductor material, in particular of YBa₂Cu₃O₇₋ₓ.

## Patentansprüche

1. Verfahren zur Festkörpersynthese von keramischen Materialien, insbesondere von Oxidmaterialien, insbesondere von Cupraten, umfassend oder bestehend aus den folgenden Schritten:
Bereitstellen von Ausgangsmaterial (A, B, C) in einer Heizvorrichtung (1) in einem Bereitstellungsschritt (a) in Mengen, die zur Herstellung des keramischen Materials wirksam sind, nachfolgend
Anwenden einer Behandlung auf das besagte Ausgangsmaterial (A, B, C) in einem Behandlungsschritt (b) unter Verwendung einer darin enthaltenen Festkörperreaktion, wobei der Behandlungsschritt (b) beinhaltet:
Erwärmen des Ausgangsmaterials (A, B, C) mittels der Heizvorrichtung (1) in einem Heizschritt (c) auf eine erste Reaktionstemperatur (*T₁*), wobei die erste Reaktionstemperatur (*T₁*) in einem Bereich von 650 Grad Celsius bis 1200 Grad Celsius liegt, bevorzugt in einem Bereich von 750 Grad Celsius bis 1000 Grad Celsius, besonders bevorzugt in einem Bereich von 850 Grad Celsius bis 950 Grad Celsius, und insbesondere von 900 Grad Celsius, und
Bestrahlen des besagten Ausgangsmaterials (A, B, C) während mindestens einer ersten vorbestimmten Zeitperiode (*t₁*) mit ultraviolettem Licht in einem Bestrahlungsschritt (d) während mindestens eines Teils von und/oder nach dem Heizschritt (c).

2. Verfahren nach Anspruch 1, umfassend die weiteren Schritte:
Mischen der Ausgangsmaterialien (A, B, C), insbesondere Oxidmaterialien, um eine Pulvermischung herzustellen; nachfolgend
Pressen der besagten Pulvermischung; und
Anwenden des Behandlungsschritts (b).

3. Verfahren nach Anspruch 1 oder 2, wobei in dem Bestrahlungsschritt (d) das ultraviolette Licht während mindestens einer ersten vordefinierten Zeitspanne (*t1*) mit einer Lichtbestrahlungsstärke (4) in einem Bereich von 0,5 W/cm² bis 5 W/cm² bestrahlt wird, bevorzugt in einem Bereich von 1 W/cm² bis 4 W/cm², besonders bevorzugt in einem Bereich von 1,5 W/cm² bis 3 W/cm² und insbesondere von 2 W/cm².

4. Verfahren nach irgendeinem der Ansprüche 1 bis 3, wobei das erhitzte Material (A, B, C) für eine zweite vordefinierte Zeitspanne (*t₂*) auf der ersten Reaktionstemperatur (*T₁*) gehalten wird, wobei vorzugsweise die zweite vordefinierte Zeitspanne (*t₂*) der Ultraviolett-LichtBestrahlung in einem Bereich von 10, 20 oder 30 Sekunden bis 5 Stunden liegt, vorzugsweise in einem Bereich von 1 Minute bis 1 Stunde, bevorzugter in einem Bereich von 15 Minuten bis 45 Minuten, und insbesondere von 20 Minuten oder 30 Minuten.

5. Verfahren nach Anspruch 4, wobei die erste vordefinierte Zeitspanne (*t₁*) mindestens ein Teil der zweiten vordefinierten Zeitspanne (*t₂*) ist.

6. Verfahren nach irgendeinem der Ansprüche 1 bis 5, wobei das ultraviolette Licht kontinuierlich und/oder in Form eines oder mehrerer aufeinanderfolgender Lichtimpulse eingestrahlt wird.

7. Verfahren nach Anspruch 6, wobei eine Länge von Lichtimpulsen in einem Bereich von 100 Nanosekunden bis 2 Millisekunden liegt, vorzugsweise in einem Bereich von 1 Mikrosekunde bis 500 Mikrosekunden, und insbesondere von 100 Mikrosekunden.

8. Verfahren nach irgendeinem der Ansprüche 1 bis 7, wobei das Ausgangsmaterial (A, B, C) der Heizvorrichtung (1) in im wesentlichen stöchiometrischen Mengen bereitgestellt wird.

9. Verfahren nach irgendeinem der Ansprüche 1 bis 8, wobei das Ausgangsmaterial (A, B, C) durch Bestrahlung mit elektromagnetischen Wellen erhitzt wird, vorzugsweise durch Bestrahlung mit Mikrowellen oder mittels Halogenlampen (5).

10. Verfahren nach irgendeinem der Ansprüche 1 bis 9, wobei das Ausgangsmaterial (A, B, C) als eine homogene Mischung von Pulvermaterialien bereitgestellt wird.

11. Verfahren zur Herstellung eines dünnen Films aus keramischen Materialien, insbesondere aus Oxidmaterialien, insbesondere aus Kupraten, umfassend das Verfahren nach irgendeinem der Ansprüche 1 bis 9 ohne die Ansprüche 2 und 8, umfassend die Schritte:
in dem Bereitstellungsschritt (a), Auflösen des Ausgangsmaterials (A, B, C) in im wesentlichen stöchiometrischen Mengen in einem Lösungsmittel; nachfolgend
Beschichten eines Substrats, vorzugsweise durch eine Tauch- und/oder Schleuderbeschichtungstechnik, um ein beschichtetes Substrat herzustellen; nachfolgend
in dem Behandlungsschritt (b), Erwärmen des beschichteten Substrats durch Anwenden des Heizschrittes (c) nach irgendeinem der vorhergehenden Ansprüche, vorzugsweise mittels Halogenlampen und vorzugsweise bei 900 Grad Celsius und während 20 Minuten;
wobei das beschichtete Substrat mit ultraviolettem Licht bestrahlt wird, indem der Bestrahlungsschritt (d) nach irgendeinem der vorhergehenden Ansprüche während mindestens eines Teils des besagten Heizschrittes (c) durchgeführt wird.

12. Verfahren nach Anspruch 11, wobei nach dem Tauchbeschichten oder dem Schleuderbeschichten des Substrats die abgeschiedene Dünnfilmbeschichtung auf dem Substrat getrocknet wird, vorzugsweise bei einer Temperatur in einem Bereich von 200 Grad Celsius bis 250 Grad Celsius, vorzugsweise für 10 Minuten bis 15 Minuten.

13. Verfahren nach Anspruch 11 oder 12, wobei nach dem Heizschritt (c) die auf dem Substrat abgeschiedene Dünnfilmbeschichtung in Sauerstoffatmosphäre bei einer zweiten Temperatur (*T*₂), wobei die zweite Temperatur (*T*₂) vorzugsweise niedriger ist als die erste Temperatur (*T₁*), vorzugsweise 550° Celsius; und für eine vordefinierte Zeitspanne von vorzugsweise 10 Minuten bis 30 Minuten, bevorzugter von 20 Minuten, geglüht wird.

14. Verfahren nach irgendeinem der Ansprüche 11 bis 13, wobei die erhitzte bestrahlte Dünnfilmbeschichtung auf dem Substrat unter Sauerstofffluss auf Raumtemperatur abgekühlt wird.

15. Verfahren nach irgendeinem der Ansprüche 11 bis 14, wobei vor dem besagten Heizschritt (c) die Beschichtung des Substrats mit Ultraviolettstrahlung durch Anwendung des Bestrahlungsschrittes (d) bestrahlt wird.

16. Verfahren zur Herstellung eines dünnen Films aus keramischen Materialien, insbesondere aus Oxidimaterialien, insbesondere aus Kupraten, umfassend ein Verfahren nach irgendeinem der Ansprüche 1 bis 9 ohne die Ansprüche 2 und 8, wobei ein durch den dünnen Film zu beschichtendes Substrat durch eine Abscheidungskammer hindurchgeführt wird, welche vorzugsweise mindestens eine Vakuumkammer umfasst, und die mindestens eine Heizeinrichtung, mindestens ein Ausgangsmaterialzuführsystem und ein Substratdurchführungssystem zum Verschieben des Substrats durch eine Abscheidungszone der Metalloxidabscheidungskammer umfasst,
wobei während des Bereitstellungsschritts (a) das sich durch die Abscheidungszone bewegende Substrat durch die Heizeinrichtung erwärmt und nacheinander mit dem Ausgangsmaterial mit Hilfe des Ausgangsmaterialzuführungssystems beaufschlagt wird, um eine Beschichtung darauf abzuscheiden,
und wobei während des Behandlungsschrittes (b) die Beschichtung in dem Bestrahlungsschritt (d) mit ultraviolettem Licht bestrahlt wird.

17. Verfahren nach Anspruch 11 oder 16, wobei das Ausgangsmaterial dem Substrat durch ein Verfahren bereitgestellt wird, das ausgewählt ist aus der Gruppe umfassend metallorganische Abscheidung, Flüssigphasen-Epitaxie, Ionenstrahl-Epitaxie, gepulste Laserabscheidung, Ionenstrahl-unterstützte Abscheidung.

18. Verwendung des Verfahrens nach irgendeinem der vorhergehenden Ansprüche zur Synthese eines Kuprat-Hochtemperaturleitermaterials, insbesondere von YBa₂Cu₃O₇₋ₓ.

## Revendications

1. Procédé pour la synthèse à l'état solide de matériaux céramiques, en particulier de matériaux d'oxyde, en particulier de cuprates, comprenant ou consistant en les étapes suivantes:
fournir un matériau de départ (A, B, C) dans une étape de fourniture (a) à un dispositif de chauffage (1) dans des quantités effectives pour produire le matériau céramique; ci-après
appliquer un traitement audit matériau de départ (A, B, C) dans une étape de traitement (b) en utilisant une réaction à l'état solide, dans lequel l'étape de traitement (b) comprend:
chauffer le matériau de départ (A, B, C) au moyen du dispositif de chauffage (1) dans une étape de chauffage (c) jusqu'à une première température de réaction (*T₁*), où la première température de réaction (*T₁*) se situe dans une plage de 650 degrés Celsius à 1200 degrés Celsius, de préférence dans une plage de 750 degrés Celsius à 1000 degrés Celsius, plus préférablement dans une plage de 850 degrés Celsius à 950 degrés Celsius, et en particulier 900 degrés Celsius, et
irradier ledit matériau de départ (A, B, C) pendant au moins une première période prédéfinie (*T₁*) avec de la lumière ultraviolette dans une étape d'irradiation (d) pendant au moins une partie et/ou après l'étape de chauffage (c).

2. Procédé selon la revendication 1, comprenant les étapes supplémentaires consistant en:
mélanger les matériaux de départ (A, B, C), en particulier des matériaux d'oxyde, pour préparer un mélange de poudres; ci-après,
presser ledit mélange de poudres; et
appliquer l'étape de traitement (b).

3. Procédé selon la revendication 1 ou 2, dans lequel, dans l'étape d'irradiation (d), la lumière ultraviolette est irradiée pendant au moins une première période prédéfinie (*t₁*) avec une intensité d'irradiation (4) dans une plage de 0,5 W/cm² à 5 W/ 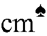 , de préférence dans une plage de 1 W/cm² à 4 W/cm², plus préférablement dans une plage de 1,5 W/cm² à 3 W/cm², et en particulier de 2 W/cm².

4. Procédé selon l'une quelconque des revendications 1 à 3, dans lequel le matériau chauffé (A, B, C) est maintenue à la première température de réaction (*T₁*) pendant une seconde période de temps prédéfinie (*t₂*), dans lequel, de préférence, la seconde période de temps prédéfinie (*t₂*) d'irradiation par la lumière ultraviolette est dans une plage de 10, 20 ou 30 secondes à 5 heures, de préférence dans une plage de 1 minute à 1 heure, plus préférablement dans une plage de 15 minutes à 45 minutes , et en particulier de 20 minutes ou 30 minutes.

5. Procédé selon la revendication 4, dans lequel la première période de temps prédéfinie (*t₁*) fait au moins une partie de la deuxième période de temps prédéfinie (*t₂*).

6. Procédé selon l'une quelconque des revendications 1 à 5, dans lequel la lumière ultraviolette est irradiée en continu et/ou sous la forme d'une ou d'une pluralité d'impulsions lumineuses consécutives.

7. Procédé selon la revendication 6, dans lequel une longueur des impulsions lumineuses est dans une plage de 100 nanosecondes à 2 millisecondes, de préférence dans une plage de 1 microseconde à 500 microsecondes, et en particulier de 100 microsecondes.

8. Procédé selon l'une quelconque des revendications 1 à 7, dans lequel le matériau de départ (A, B, C) est fourni au dispositif de chauffage (1) en quantités sensiblement stoechiométriques.

9. Procédé selon l'une quelconque des revendications 1 à 8, dans lequel le matériau de départ (A, B, C) est chauffé par irradiation d'ondes électromagnétiques, de préférence par irradiation de micro-ondes ou au moyen de lampes halogènes (5).

10. Procédé selon l'une quelconque des revendications 1 à 9, dans lequel le matériau de départ (A, B, C) est fourni sous la forme d'un mélange homogène de matières en poudre.

11. Procédé de préparation d'un film mince de matériaux céramiques, en particulier de matériaux d'oxyde, en particulier de cuprates, selon un procédé selon l'une quelconque des revendications 1 à 9 sans les revendications 2 et 8, comprenant les étapes de:
dissoudre, dans l'étape de fourniture (a), le matériau de départ (A, B, C) dans des quantités sensiblement stoechiométriques dans un solvant; ci-après,
revêtir un substrat de préférence par une technique de revêtement par immersion et/ou par centrifugation pour produire un substrat revêtu; ci-après,
chauffer, dans l'étape de traitement (b), le substrat revêtu en appliquant l'étape de chauffage (c) selon l'une quelconque des revendications précédentes, de préférence au moyen de lampes halogènes et, de préférence, à 900 degrés Celsius et pendant 20 minutes;
dans lequel le substrat revêtu est irradié avec de la lumière ultraviolette en appliquant l'étape d'irradiation (d) selon l'une quelconque des revendications précédentes pendant au moins une partie de ladite étape de chauffage (c).

12. Procédé selon la revendication 11, dans lequel, après le revêtement par immersion ou le revêtement par centrifugation du substrat, le revêtement de film mince déposé sur le substrat est séché, de préférence à une température comprise entre 200 degrés Celsius et 250 degrés Celsius, de préférence pendant 10 minutes jusqu'à 15 minutes.

13. Procédé selon la revendication 11 ou 12, dans lequel, après l'étape de chauffage (c), le revêtement de film mince déposé sur le substrat est recuit dans une atmosphère d'oxygène à une seconde température (*T*₂), la seconde température (*T*₂) étant de préférence inférieure à la première température (*T₁*), de préférence 550 degrés Celsius; et pendant une durée prédéfinie de préférence de 10 minutes à 30 minutes, plus préférablement de 20 minutes.

14. Procédé selon l'une quelconque des revendications 11 à 13, dans lequel le revêtement de film mince irradié et chauffé sur le substrat est refroidi à la température ambiante sous flux d'oxygène.

15. Procédé selon l'une quelconque des revendications 11 à 14, dans lequel, avant ladite étape de chauffage (c), le revêtement du substrat est irradié avec une irradiation ultraviolette en appliquant l'étape d'irradiation (d).

16. Procédé de préparation d'un film mince de matériaux céramiques, en particulier de matériaux d'oxyde, en particulier de cuprates, selon un procédé selon l'une quelconque des revendications 1 à 9 sans les revendications 2 et 8, dans lequel un substrat à revêtir par le film mince est déplacé à travers d'une chambre de dépôt, laquelle comprend au moins une chambre à vide et laquelle comprend au moins un dispositif de chauffage, au moins un système de distribution de matériau de départ et un système de transfert de substrat pour transférer le substrat à travers une zone de dépôt de la chambre de dépôt d'oxyde métallique,
dans lequel, pendant l'étape de fourniture (a), le substrat transféré à travers la zone de dépôt est chauffé par le dispositif de chauffage dans l'étape de chauffage (c) et est successivement heurté par le matériau de départ au moyen du système de distribution de matériau de départ afin de déposer un revêtement sur celui-ci,
et dans lequel, pendant l'étape de traitement (b), le revêtement est irradié dans l'étape d'irradiation (d) par de la lumière ultraviolette.

17. Procédé selon la revendication 11 ou 16, dans lequel le matériau de départ est fourni au substrat par un procédé choisi dans le groupe comprenant le dépôt organométallique, l'épitaxie en phase liquide, l'épitaxie par faisceau d'ions, le dépôt par laser pulsé, le dépôt assisté par faisceau d'ions.

18. Utilisation du procédé selon l'une quelconque des revendications précédentes pour la synthèse d'un matériau conducteur cuprate à haute température, notamment de YBa₂Cu₃O₇₋ₓ.
